# EUROPEAN PATENT APPLICATION

(11) **EP 4 517 811 A1**
(43) Date of publication of application: **05.03.2025**
(21) Application number: 24192158.4
(22) Date of filing: 31.07.2024
(51) Int. Cl.: H01L 23/31, H01L 23/367, H01L 23/485

(54) **SEMICONDUCTOR DEVICE AND ELECTRONIC APPARATUS**

(30) Priority: 28.08.2023 JP 2023138249
(71) Applicant: FUJITSU LIMITED, Kawasaki-shi, Kanagawa 211-8588 (JP)
(72) Inventor: SASAKI, Shinya, Kawasaki-shi, 211-8588 (JP); NAKATA, Yoshihiro, Kawasaki-shi, 211-8588 (JP)
(74) Representative: Haseltine Lake Kempner LLP

(57) **Abstract**

To provide a highly reliable semiconductor device and an electronic apparatus.

[Solution]

A semiconductor device (100) includes a semiconductor chip (110) having a first surface facing a substrate (10) and a second surface opposite to the first surface, the second surface being a circuit surface; a first bump (140A) connecting the first surface of the semiconductor chip and the substrate; and a metallic pillar (150) connecting the first surface of the semiconductor chip and the substrate.

## Description

### FIELD

The present disclosure relates to a semiconductor device and an electronic apparatus.

### BACKGROUND

The related art technology discloses a packaging structure including a circuit board, a bonding portion disposed on the circuit board, and an electronic component connected to the circuit board via the bonding portion, in which the bonding portion includes a solder base portion and a metallic layer formed on a surface of the solder base portion and having an electrical resistivity lower than that of the solder base portion (for example, see Japanese Patent Application Laid-Open No. 2022-116980).

### SUMMARY

In the related-art packaging structure (semiconductor device), when the packaging density of the bonding portions is increased, solder bridging in which the bonding portions having the solder base portions are connected to each other is generated, and thus the reliability of the semiconductor device may be deteriorated. This is also true for electronic apparatuses including semiconductor devices.

In view of the above, it is an object in one aspect of the embodiment to provide a highly reliable semiconductor device and electronic apparatus.

According to an aspect of the embodiment of the present disclosure, a semiconductor device includes a semiconductor chip having a first surface and a second surface, the first surface facing a substrate, and the second surface being opposite to the first surface and being a circuit surface; a first bump connecting the first surface of the semiconductor chip and the substrate; and a metallic pillar connecting the first surface of the semiconductor chip and the substrate.

### ADVANTAGEOUS EFFECT

A highly reliable semiconductor device and electronic apparatus can be provided.

The object and advantages of the invention will be realized and attained by means of the elements and combinations particularly pointed out in the claims.

It is to be understood that both the foregoing general description and the following detailed description are exemplary and explanatory and are not restrictive of the invention, as claimed.

### BRIEF DESCRIPTION OF DRAWINGS

FIG. 1 is a diagram illustrating an example of a cross-sectional configuration of a semiconductor device 100 according to an embodiment.
FIG. 2 is a diagram illustrating an example of an arrangement of regions A and B, solder balls 140A and 140B, and a metallic pillar 150.
FIG. 3 is a diagram illustrating an example of a simulation result using a simulation model of the electronic apparatus 1.
FIG. 4 is a diagram illustrating an electronic apparatus 1A according to a first modification of the embodiment.
FIG. 5 is a diagram illustrating a semiconductor device 100B and an electronic apparatus 1 according to a second modification of the embodiment.

### DESCRIPTION OF EMBODIMENTS

Hereinafter, embodiments to which a semiconductor device and an electronic apparatus of the present disclosure are applied will be described with reference to the accompanying drawings. In the following description, the same elements are denoted by the same reference numerals, and redundant description may be omitted.

In the following description, an XYZ coordinate system is defined. A direction parallel to the X-axis (X-direction), a direction parallel to the Y-axis (Y-direction), and a direction parallel to the Z-axis (Z-direction) are orthogonal to each other. The X direction is an example of a first axis direction, the Y direction is an example of a second axis direction, and the Z direction is an example of a third axis direction. In the following description, for convenience of description, the -Z direction side may be referred to as a lower side or a bottom, and the +Z direction side may be referred to as an upper side or a top, but these do not represent a universal vertical relationship. Further, the plan view means an XY plane view.

In the following description, the length, thickness, and the like of each portion may be exaggerated for facilitating understanding of the configuration. In addition, the terms "parallel", "perpendicular", "orthogonal", "horizontal", "vertical", "upper", "lower", and the like allow a deviation to the extent that the effect of the embodiment is not impaired.

In the following description, the term "millimeter wave" or "millimeter waveband" includes not only the 30 GHz to 300 GHz band but also the quasi-millimeter waveband from 24 GHz to 30 GHz.

### <Embodiment>

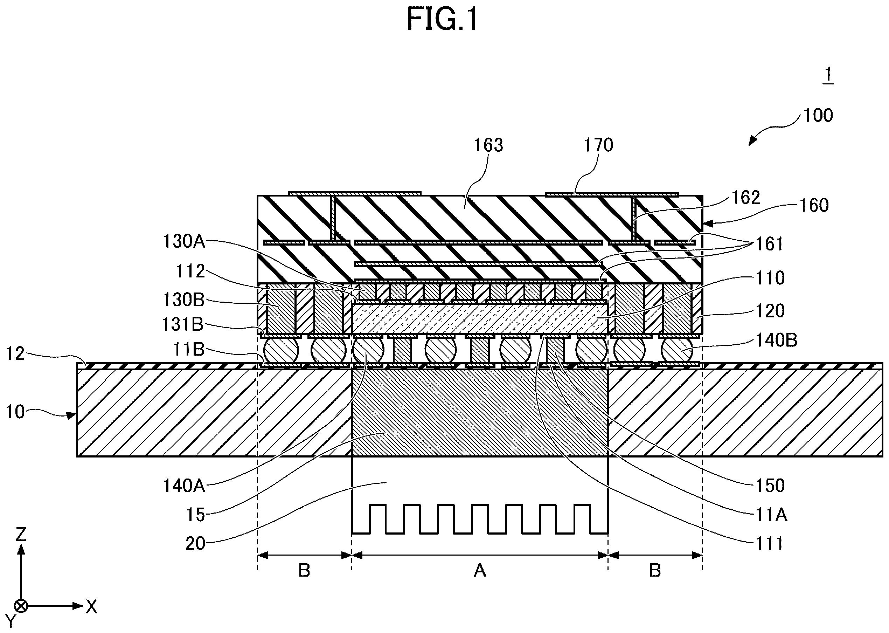

FIG. 1 is a diagram illustrating an example of a cross-sectional configuration of a semiconductor device 100 according to an embodiment. The semiconductor device 100 has a rectangular shape in a plan view (XY plan view) as an example, and FIG. 1 illustrates a cross-sectional configuration parallel to an XZ plane. FIG. 1 illustrates an XZ cross section at a certain position in the Y direction.

As an example, the semiconductor device 100 includes a semiconductor chip 110, a mold resin 120, metallic pillars 130A and 130B, solder balls 140A and 140B, a metallic pillar 150, a redistribution layer 160, and an antenna 170. The solder ball 140A is an example of a first bump, and the solder ball 140B is an example of a second bump. The metallic pillar 150 is an example of a metallic pillar. In FIG. 1, the number of solder balls 140A and 140B and the number of metallic pillars 150 are reduced in illustration for facilitating understanding of the cross-sectional structure of the semiconductor device 100.

The semiconductor device 100 is mounted on a radio frequency (RF) board 10 via solder balls 140A and 140B and a metallic pillar 150. The semiconductor device 100 is mounted on the RF board 10 by a reflow process. The semiconductor device 100 is a semiconductor package including a semiconductor chip 110. The electronic apparatus 1 according to the embodiment includes a semiconductor device 100, an RF board 10, and a heat sink 20. The RF board 10 is an example of a substrate.

The semiconductor device 100 is, for example, a semiconductor package (Antenna in Package: AiP) in which an antenna 170 as an RF antenna is included. The semiconductor device 100 is a wireless communication device that can be mounted on a radio unit (RU) of a front end of a base station as an example. The RF board 10 is, for example, a motherboard of a base station.

The AiP has a structure in which a signal is amplified by the semiconductor chip 110 included therein and a radio wave is transmitted from the antenna 170. That is, amplification of a signal and complex signal processing are performed in the semiconductor chip 110. The semiconductor chip 110 includes, in one package, a function of modulating a signal into a highfrequency signal, amplifying the signal, and radiating a radio wave into space via the plurality of antennas 170 constituting an array antenna.

In recent mobile communication systems (for example, the fifth generation mobile communication system (5G)), for example, in order to support ultra-high-speed communication, ultra-low delay, and multiple simultaneous connections, utilization or consideration of millimeter wave band frequencies is in progress. In order to achieve high output power in the AiP for a base station, it is necessary to dispose an RF chip including a heat-emitting unit such as a power amplifier in the vicinity of the antenna 170 and to radiate a radio wave with a low loss and a high output with less signal attenuation from the antenna 170. For this reason, the semiconductor device 100 needs to be downsized. In addition, since the semiconductor device 100 includes the plurality of antennas 170 mounted by the patch antennas, it is necessary to arrange the antennas 170 having a small size corresponding to a short wavelength, and the pitch between the antennas 170 is shortened, and thus, the miniaturization is required. In addition, the semiconductor device 100 includes a high-output power amplifier and the like, and thus requires a heat dissipation mechanism with extremely high efficiency.

### <Regions A and B>

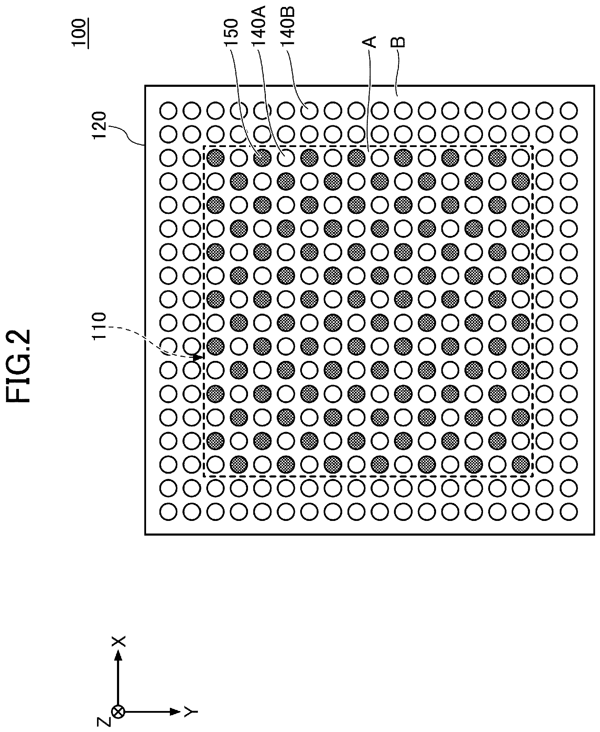

The semiconductor device 100 has regions A and B in a plan view. Here, description will be given with reference to FIG. 2 in addition to FIG. 1. FIG. 2 is a diagram illustrating an example of the arrangement of the regions A and B, the solder balls 140A and 140B, and the metallic pillar 150. FIG. 2 illustrates the semiconductor device 100 from the -Z direction side (lower side). FIG. 2 illustrates the solder balls 140A and 140B and the metallic pillars 150 disposed in an array of 18 × 18 in the X-axis direction and the Y-axis direction as an example.

The region A is a rectangular region where the semiconductor chip 110 is present in a plan view. The region A is located in the central portion of the semiconductor device 100 in a plan view. A region B is a rectangular annular region surrounding the region A. More specifically, as an example, the region A is a rectangular region overlapping the semiconductor chip 110 in a plan view, the region B is a rectangular annular region outside the region A, and the outer edge of the region B is equal to the outer edge of the rectangular region where the semiconductor device 100 exists.

Among the components of the semiconductor device 100, the metallic pillar 130A, the solder ball 140A, and the metallic pillar 150 are located in the region A, and the metallic pillar 130B and the solder ball 140B are located in the region B.

As illustrated in FIG. 2, in the region A, the solder balls 140A and the metallic pillars 150 are disposed in an array of 14 × 14 in the X-axis direction and the Y-axis direction. In the region A, the solder balls 140A and the metallic pillars 150 are both present. In the region B, the solder balls 140B are arranged in a double rectangular ring shape so as to surround the region A. The arrangement of the solder balls 140A and 140B and the metallic pillars 150 will be described in detail later.

### <RF Board 10>

The RF board 10 includes pads 11A and 11B, a resist 12, and a metallic portion 15. The pads 11A and 11B are disposed on the surface on the +Z direction side of the RF board 10, and a resist 12 is disposed on a portion of the surface on the +Z direction side of the RF board 10 where the pads 11A and 11B are not disposed.

The pad 11A is disposed in the region A, and the pad 11B is disposed in the region B. The solder ball 140A and the metallic pillar 150 are connected to the upper surface of the pad 11A, and the lower surface of the pad 11A is connected to the metallic portion 15. The solder ball 140B of the semiconductor device 100 is connected to the pad 11B. The pad 11A is, for example, a pad (terminal) included in a path for releasing heat of the semiconductor device 100 to the metallic portion 15 via the solder ball 140A and the metallic pillar 150. The pad 11B is a pad (terminal) for transmitting power and clock signals of the semiconductor device 100.

The metallic portion 15 is provided for cooling the semiconductor chip 110, and is disposed in a through hole that penetrates the RF board 10 in the Z direction directly below the semiconductor chip 110 of the semiconductor device 100, for example. The metallic portion 15 is, for example, a mass of metal having high thermal conductivity such as aluminum or copper. The upper surface of the metallic portion 15 is connected to the lower surface of the pad 11A. A heat sink 20 is attached directly below the metallic portion 15. A heat conductive sheet or the like may be disposed between the lower surface of the metallic portion 15 and the upper surface of the heat sink 20.

Heat emitted from the semiconductor chip 110 is conducted to the metallic portion 15 via the pad 111, the solder ball 140A, the metallic pillar 150, and the pad 11A. The heat conducted to the metallic portion 15 is further conducted to the heat sink 20 and is released from the heat sink 20 into the air. In this way, the semiconductor chip 110 is cooled. The heat sink 20 is, for example, an air-cooled heat sink made of metal having high thermal conductivity, such as aluminum or copper.

The pads 11A and 11B may be made of metals such as copper or aluminum, for example. In particular, the pad 11A is preferably made of a material having high thermal conductivity, such as copper or aluminum, because the pad 11A contributes to heat dissipation of the semiconductor device 100.

A resist 12 is a protective film that protects the surface of the RF board 10 on the +Z direction side. The upper surfaces of the pads 11A and 11B are exposed from the resist 12.

### <Semiconductor Chip 110>

The semiconductor chip 110 is a Radio Frequency Integrated Circuit (RFIC) fabricated by a semiconductor fabrication process. The semiconductor chip 110 is fabricated based on a silicon substrate or the like as an example. The semiconductor chip 110 is covered with the mold resin 120 except for the surface on the -Z direction side.

The surface of the semiconductor chip 110 on the +Z direction side is, for example, a circuit surface for inputting and outputting an electrical signal when the semiconductor chip 110 operates as a circuit. The semiconductor chip 110 uses, for example, the surface on the -Z direction side as a path for releasing heat of the semiconductor chip 110.

Note that, in order to further increase the circuit surface of the semiconductor chip 110, the surface of the semiconductor chip 110 on the -Z direction side may also be used as a surface for inputting and outputting an electric signal when the semiconductor chip 110 operates as a circuit in addition to being used as a path for releasing heat of the semiconductor chip 110. That is, the circuit surface of the semiconductor chip 110 may be the surface on the +Z direction side and a part of the surface on the -Z direction side. Note that, as an example, a mode in which an electric signal is not input and output when the surface of the semiconductor chip 110 on the -Z direction side operates as a circuit will be described below.

The semiconductor chip 110 includes pads 111 disposed on the surface on the -Z direction side and pads 112 disposed on the surface on the +Z direction side. The solder ball 140A and the metallic pillar 150 are connected to the pad 111. The pad 112 is connected to the metallic pillar 130A. The pads 111 and 112 may be made of metal such as copper or aluminum, for example. In particular, the pad 111 contributes to heat dissipation of the semiconductor chip 110, and therefore is preferably made of metal having high thermal conductivity such as copper or aluminum.

The semiconductor chip 110 includes, for example, a wireless communication circuit such as a power amplifier for transmission, a low noise amplifier (LNA) for reception, and the like; and a control circuit that controls a beam angle in beam forming described below. The wireless communication circuit and the control circuit are connected to the pad 112 via a wiring or the like (not illustrated). The pad 112 is connected to the antenna 170 via the redistribution layer 160.

### <Mold Resin 120>

The mold resin 120 is filled between the side surface and upper surface of the semiconductor chip 110 and the metallic pillars 130A and 130B. The mold resin 120 is made of, for example, a thermosetting resin such as an epoxy resin. For example, the metallic pillars 130A and 130B are formed in a state where the redistribution layer 160 is placed turned upside down, and the semiconductor chip 110 is connected to the metallic pillar 130A. Then, a thermosetting resin is filled around the semiconductor chip 110 to form the mold resin 120.

### <Metallic Pillar 130A>

A plurality of metallic pillars 130A are disposed in the region A. The plurality of metallic pillars 130A are disposed two dimensionally in the region A. Each of the metallic pillars 130A has a lower end connected to the pad 112 on the upper surface of the semiconductor chip 110 and an upper end extending to the upper surface of the mold resin 120. The upper end of the metallic pillar 130A illustrated in FIG. 1 is connected to the interconnect layer 161 on the lower surface of the redistribution layer 160. The metallic pillars 130A illustrated in FIG. 1 transmit electrical signals between the pads 112 of the semiconductor chip 110 and the interconnect layer 161 on the lower surface of the redistribution layer 160. In the present embodiment, as an example, the metallic pillars 130A illustrated in FIG. 1 are connected to the wireless communication circuit of the semiconductor chip 110 via the pads 112, and transmit a wireless communication signal. In addition, metallic pillars 130A not illustrated in FIG. 1 are connected to the metallic pillars 130B via the redistribution layer 160 to transmit power and a clock signal.

The material composition or the forming method of the metallic pillars 130A is not particularly specified. Examples of metals that can be used to form the metallic pillars 130A include copper, nickel, silver, gold, aluminum, chrome, zinc, and alloys containing these metals. Further, examples of the method for forming the metallic pillars 130A include electroplating, electroless plating, and wire bonding. The metallic pillars 130A located on the upper side of the semiconductor chip 110 are less affected by heat than the metallic pillars 150 described later, and thus may be made of a metal having lower thermal conductivity than the metallic pillars 150.

### <Metallic Pillar 130B and Pad 131B>

A plurality of metallic pillars 130B are disposed in the region B. The plurality of metallic pillars 130B are disposed two dimensionally in the rectangular annular region B. Each of the metallic pillars 130B has a lower end connected to the pad 131B and an upper end connected to the lower surface of the redistribution layer 160. The pads 131B are exposed on the lower surface of the mold resin 120 in the region B. The upper ends of the metallic pillars 130B are connected to metallic pillars 130A not illustrated in FIG. 1 via the redistribution layer 160.

The pads 131B are exposed on the lower surface of the mold rein 120 in the region B and are connected to the solder balls 140B. Power and a clock signal are input to the metallic pillars 130B from the RF board 10 via the solder balls 140B. The power and the clock signal input to the metallic pillars 130B are input to the semiconductor chip 110 via the redistribution layer 160 and the metallic pillars 130A not illustrated in FIG. 1.

As an example, as in the metallic pillar 130A, the material composition or the forming method of the metallic pillar 130B is not particularly specified. The metals and the forming method that can be used to form the metallic pillar 130B are the same as the metals and the forming method that can be used to form the metallic pillar 130A.

### <Solder Ball 140A>

The solder balls 140A are disposed between the pads 11A on the upper surface of the RF board 10 and the pads 111 on the lower surface of the semiconductor chip 110 in the region A. The solder ball 140A and the solder ball 140B are each a solder ball for a ball grid array (BGA).

As illustrated in FIG. 2, the solder balls 140A are alternately arranged with the metallic pillars 150 in the X direction and the Y direction in the region A in a plan view. The solder balls 140A are arranged in a staggered manner in the region A in plan view. Therefore, the metallic pillars 150 are also arranged in a staggered manner in the region A in a plan view.

The solder balls 140A have a configuration in which the solder balls for BGA arranged in a matrix at equal intervals in the X direction and the Y direction are arranged at every other grid location in the X direction and the Y direction in the region A. The reason for such an arrangement will be described later together with the configuration of the metallic pillars 150.

As the solder balls 140A, for example, tin-silver (SnAg) solder, tin-silver-copper (SnAgCu) solder, or the like can be used. However, solders other than these solders may be used. Further, a metallic layer made of nickel, gold, or the like may be disposed on the surfaces of the solder balls 140A.

### <Solder Ball 140B>

The solder balls 140B are disposed between the pads 11B on the upper surface of the RF board 10 and the metallic pillars 130B in the region B. The solder ball 140B and the solder ball 140A are each a solder ball for a ball grid array (BGA).

As the solder balls 140B, for example, tin-silver (SnAg) solder, tin-silver-copper (SnAgCu) solder, or the like can be used as in the case of the solder balls 140A, but solders other than these solders may be used. Further, a metallic layer made of nickel, gold, or the like may be disposed on the surfaces of the solder balls 140B.

### <Metallic pillar 150>

As illustrated in FIG. 1, the metallic pillar 150 is disposed between the pad 11A on the upper surface of the RF board 10 and the pad 111 on the lower surface of the semiconductor chip 110. In addition, a plurality of metallic pillars 150 are provided as illustrated in FIG. 2. The plurality of metallic pillars 150 are alternately arranged with the solder balls 140A in the X direction and the Y direction in the region A in a plan view. The plurality of metallic pillars 150 are arranged in a staggered manner in the region A in a plan view.

The metallic pillars 150 located below the semiconductor chip 110 are greatly affected by the heat of the semiconductor chip 110, and therefore may be made of metal having higher thermal conductivity than solder, and the material composition or the forming method is not particularly specified. In other words, the metallic pillars 150 may be made of any metallic material having higher thermal conductivity than the solder balls 140A. Examples of the metal that can be used to form the metallic pillars 150 include copper, nickel, silver, gold, aluminum, chromium, zinc, and alloys containing these metals. Among these, copper or aluminum, which has a particularly high thermal conductivity and for which a fabrication method has been established, is preferable as the metal that can be used to form the metallic pillars 150. The metallic pillars 150 may be formed by, for example, electroplating, electroless plating, or wire bonding.

A thin solder layer may be used to connect the lower end of the metallic pillars 150 to the pads 11A. As the solder of the solder layer, solder such as tin-silver (SnAg) solder or tin-silver-copper (SnAgCu) solder can be used, but solders other than these solders may be used. A metallic layer made of nickel, gold, or the like may be disposed on the surface of the solder layer.

In addition, a metal paste containing solder or metal fine powder may be present at the mounting interface between the metallic pillars 150 and the RF board 10. Even when the solder or the metal paste is present, most of the heat conduction paths are of the metallic pillars 150 having high thermal conductivity, and thus there is no effect on decreasing thermal resistance, and the solder or the metal past is effective from the viewpoint of increasing the bonding strength. Examples of the metal paste include silver paste and copper paste.

Here, the reason for providing the metallic pillars 150 will be described using a semiconductor device as a comparative example. The semiconductor device as the comparative example is obtained by replacing all the metallic pillars 150 of the semiconductor device 100 illustrated in FIG. 1 with solder balls 140A.

As the operating frequencies of the semiconductor chip 110 increase, for example, from 28 GHz, 39 GHz, and 47 GHz, the pitch between the antennas 170 decreases according to the frequencies. Thus, the size of the semiconductor device as the comparative example is reduced according to the pitch between the antennas 170. As the size of the semiconductor device is reduced, generated heat is concentrated on a narrow area near the semiconductor chip 110, and the heat density increases. Further, when the heat density increases, the thermal resistance of the solder balls 140A needs to be reduced. However, there is a limit to the reduction in the thermal resistance by reducing the pitch of the solder balls 140A and increasing the number of the solder balls 140A. This limit arises because the smaller the pitch of the solder balls 140A, the higher the probability of generating solder bridging.

When the solder ball 140A generating the solder bridging is not connected to the pad 111 on the lower surface of the semiconductor chip 110, the number of solder balls 140A supporting the lower surface of the semiconductor chip 110 is reduced. In such a state, compared to a state where all the solder balls 140A support the semiconductor chip 110, the semiconductor chip 110 is unnecessarily stressed and the semiconductor chip 110 is distorted, which may adversely affect the operation of the semiconductor chip 110. When the operation of the semiconductor chip 110 is adversely affected, the reliability of the semiconductor device as the comparative example is decreased.

When solder bridging is generated in the solder balls 140A in a portion near the outer edge of the region A, the portion near the outer edge of the region A of the semiconductor chip 110 is warped. When such warpage occurs, distortion or the like occurs in the metallic pillars 130B for a clock signal and power supply. 110 When the operation of the semiconductor chip 110 is adversely affected, the reliability of the semiconductor device as the comparative example is decreased.

In addition, when a circuit surface is also present in a part of the lower surface of the semiconductor chip 110, solder bridging is generated in the solder balls 140A connected to the circuit surface on the lower surface side, causing a defect in the connection of the circuit of the semiconductor chip 110, and reducing the reliability of the semiconductor device as the comparative example.

The above-described reduction in size and increase in heat density also occur in the semiconductor device 100 and the electronic apparatus 1 according to the embodiment. The reliability of the semiconductor device 100 and the electronic apparatus 1 according to the embodiment is increased by replacing some of the solder balls 140A in the region A with the metallic pillars 150.

The configuration of the metallic pillars 150 is not limited to the configuration in which the metallic pillars are arranged in a staggered manner in the region A in a plan view as illustrated in FIG. 2. For example, the metallic pillars 150 may be alternately arranged with the solder balls 140A only in the X direction in the region A in a plan view. In this case, in the region A, the fourteen metallic pillars 150 at the same position in the X direction are continuously arranged adjacent to each other in the Y direction in a plan view. The metallic pillars 150 may be alternately arranged with the solder balls 140A only in the Y direction in the region A in a plan view. In this case, in the region A, the fourteen metallic pillars 150 at the same position in the Y direction are continuously arranged adjacent to each other in the X direction in a plan view.

In the above description, the region A is a rectangular region overlapping the semiconductor chip 110 in a plan view, the region B is a rectangular annular region outside the region A, and the outer edge of the region B is equal to the outer edge of the rectangular region where the semiconductor device 100 is present. However, the region A may be larger or smaller than the rectangular region in which the semiconductor chip 110 is present in a plan view. The region A may not be rectangular, and may be circular, elliptical, or the like. The shape and size of the region A may be determined according to the heat distribution of the heat generated by the semiconductor chip 110.

The region B may not have a rectangular annular shape. For example, when the region A has a circular shape, an elliptical shape, or the like, the inner edge of the region B may be matched with the shape (circular shape or elliptical shape) of the outer edge of the region A. The outer edge of the region B may be larger or smaller than the region where the semiconductor device 100 is present. The outer edge of the region B is not limited to a rectangular shape, and may be a circular shape, an elliptical shape, or the like. The shape and size of the inner edge and the outer edge of the region B may be determined according to the heat distribution due to the heat generated by the semiconductor chip 110, as in the region A.

In the above description, the region where the semiconductor device 100 is present is divided into the rectangular region A overlapping the semiconductor chip 110 and the rectangular annular region B surrounding the region A in plan view. However, an entire region in which the semiconductor device 100 is present without the region B in a plan view may be the region A. In this case, the plurality of solder balls 140B in FIG. 1 may be replaced with the solder balls 140A and the metallic pillars 150. That is, either the solder ball 140A or the metallic pillar 150 may be connected to the lower end of each of the plurality of metallic pillars 130B.

### <Redistribution layer 160>

The redistribution layer 160 is an interconnect layer formed in a fabrication process for forming a redistribution interconnect. The redistribution layer 160 illustrated in FIG. 1 includes, for example, three interconnect layers 161, vias 162 that connect the three interconnect layers 161 in the Z direction, and an insulating layer 163. Although the insulating layer 163 is integrally illustrated in FIG. 1, a plurality of insulating layers 163 are actually disposed between the three interconnect layers 161, and on the uppermost interconnect layer 161.

The redistribution layer 160 has a configuration in which a plurality of insulating layers 163 and a plurality of interconnect layers 161 are alternately stacked, and the plurality of interconnect layers 161 are connected to each other through the vias 162. An antenna 170 is disposed on a top surface of the uppermost insulating layer 163. The antenna 170 can be fabricated in a fabrication process of fabricating a redistribution interconnect, for example.

In addition, in order to illustrate the XZ cross-section at a certain position in the Y direction, only part of the interconnect layers 161 and the vias 162 are illustrated in FIG. 1. The lowermost interconnect layer 161 is connected to the antenna 170 through the vias 162. The power supply terminals and the clock signal terminals of the semiconductor chip 110 are connected to the metallic pillars 130B through unillustrated interconnect layers and vias that are similar to the interconnect layers 161 and the vias 162.

The interconnect layer 161 is made of copper (copper foil pattern), for example. The via 162 is made of copper, for example, and connects the plurality of interconnect layers 161. The via 162 is a via having a small diameter.

The insulating layer 163 has a structure using, for example, a film material (for example, an ABF material produced by Ajinomoto Fine-Techno Co., Inc.) in which a filler such as alumina is mixed in an epoxy resin, or a resin film material such as a polyimide film.

The redistribution layer 160 may be disposed also on the lower surface of the semiconductor chip 110. The redistribution layer 160 and the semiconductor chip 110 have different linear expansion coefficients, for example. The redistribution layer 160 may be disposed on the lower surface side of the semiconductor chip 110 when distortion occurs on the lower surface side of the semiconductor chip 110. In this case, the solder balls 140A and the metallic pillars 150 may be connected to the metallic portions 15 through the interconnect layers 161 and the vias 162 of the redistribution layer 160 on the lower surface side of the semiconductor chip 110.

### <Antenna 170>

The antenna 170 is composed of a plurality of patch antennas disposed on the upper surface of the redistribution layer 160. The antenna 170 can be fabricated as a copper foil pattern, for example, in the same manner as the interconnect layer 161 and the via 162 in the fabrication process of fabricating a redistribution interconnect. The semiconductor device 100 may include at least two or more antennas 170.

The radio waves transmitted from the plurality of antennas 170 form one beam by beam forming, and the radio communication circuit in the semiconductor chip 110 controls the phases of the radio waves transmitted from the plurality of antennas 170, whereby the angle of the beam can be changed. The wireless communication circuit controls the phase of the wireless communication signal to be transmitted to the antenna 170, thereby controlling the beam angle in the beamforming.

### <Simulation Results>

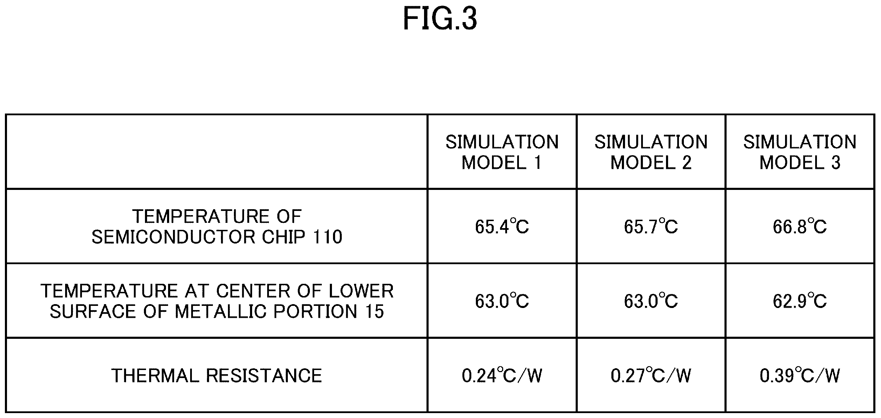

FIG. 3 is a diagram illustrating examples of simulation results using the simulation models of the electronic apparatus 1. Simulations for calculating the thermal resistance were performed using simulation models of the electronic apparatus 1.

Simulations were conducted using the simulation models 1 to 3. The simulation models 1 and 2 are simulation models of the electronic apparatus 1 according to the embodiment, and the simulation model 3 is a simulation model of a comparative electronic apparatus.

The simulation model 1 is a simulation model using the metallic pillar 150 made of copper. The simulation model 2 is a simulation model using the metallic pillar 150 made of aluminum. The simulation model 3 is a simulation model in which the metallic pillar 150 is replaced with a solder ball 140A. That is, in the simulation model 3, the solder balls 140A are formed in the entire region A.

The simulation models 1 to 3 include the semiconductor chip 110 having 9 mm in length in the X direction and the Y direction. In the simulation models 1 and 2, the pitches of the solder balls 140A and the metallic pillars 150 in the region A in the X direction and the Y direction were set to 650 µm. A solder layer made of tin-silver (SnAg) was disposed on the solder ball 140A and the lower end of the metallic pillar 150. In the simulation model 3, the pitches of the solder balls 140A in the region A in the X direction and the Y direction were set to 650 µm. A solder layer made of tin silver (SnAg) was disposed on the lower end of the solder ball 140A.

In the simulation models 1 and 2, the solder balls 140A and the metallic pillars 150 were arranged in a staggered pattern as illustrated in FIG. 2 as the center side array of 14 × 14 in the region A, among the array of 18 × 18 in the X direction and the Y direction. The number of the solder balls 140A is 98, and the number of the metallic pillars 150 is 98. In the simulation model 3, the solder balls 140A are arranged in the region A in an array of 14 × 14 in the X direction and the Y direction. In the region B in the simulation models 1 to 3, as illustrated in FIG. 2, the solder balls 140B were arranged in a double rectangular ring shape in a portion excluding an array of 14 × 14 arranged on the center side, from among the array of 18 × 18.

The thermal resistance of the heat sink 20 of each of the simulation models 1 to 3 was set to 3.5°C/W, and the simulation was performed under the condition that a thermal conductive sheet was disposed between the lower surface of the metallic portion 15 and the upper surface of the heat sink 20.

In the simulation models 1 to 3 described above, the temperature at the center of the lower surface of the metallic portion 15 of the RF board 10 and the temperature of the semiconductor chip 110 were calculated by causing the semiconductor chip 110 to generate heat at 10 W, and the thermal resistance from the semiconductor chip 110 to the center of the lower surface of the metallic portion 15 was calculated.

As illustrated in FIG. 3, the temperatures of the semiconductor chips 110 of the simulation models 1 to 3 were 65.4°C, 65.7°C, and 66.8°C, respectively, and the temperature of the semiconductor chip 110 of the simulation model 3 was higher than those of the simulation models 1 and 2.

The temperatures at the center of the lower surface of the metallic portion 15 in the simulation models 1 to 3 were 63.0°C, 63.0°C, and 62.9°C, respectively, and were substantially the same.

The thermal resistances of the semiconductor chips 110 of the simulation models 1 to 3 were 0.24°C/W, 0.27°C/W, and 0.39°C/W, respectively, and the thermal resistances of the simulation models 1 and 2 were lower than that of the simulation model 3.

As described above, the simulation models 1 and 2 in which the metallic pillars 150 are disposed in addition to the solder balls 140A in the region A have lower thermal resistance and the temperature of the semiconductor chip 110 is lower by approximately 1°C than the simulation model 3 in which only the solder balls 140A are disposed in the region A.

The above-described results illustrate that the temperature of the semiconductor chip 110 in the simulation models 1 and 2 can be made equal to or lower than the temperature of the semiconductor chip 110 in the simulation model 3 by adding the metallic pillars 150 having higher thermal conductivities than the solder balls 140A in the region A.

### <First Modification>

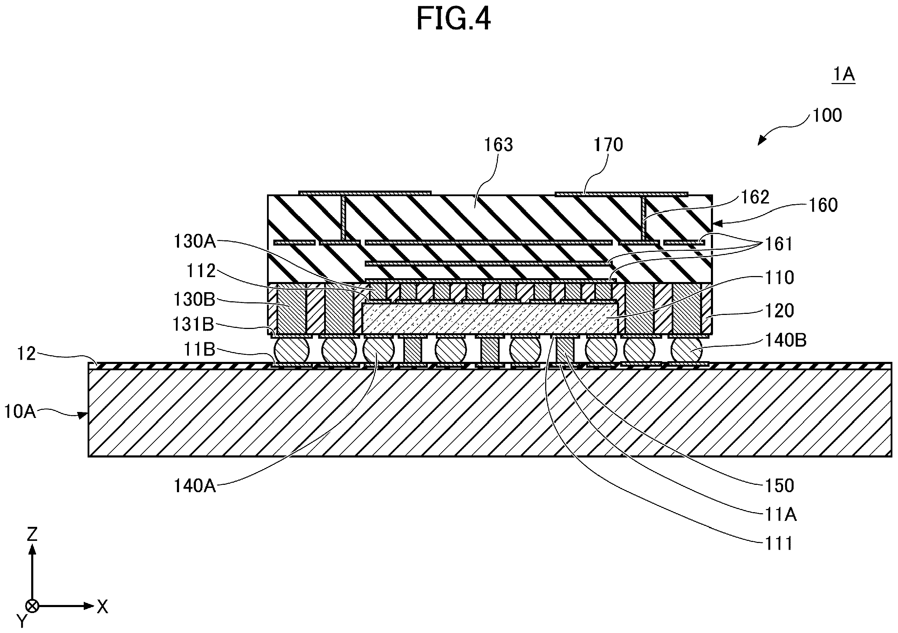

FIG. 4 is a diagram illustrating an electronic apparatus 1A according to a first modification of the embodiment. Here, differences from the electronic apparatus 1 according to the embodiment illustrated in FIGS. 1 and 2 will be described.

The electronic apparatus 1A includes the semiconductor device 100 and an RF board 10A. The electronic apparatus 1A has a configuration in which the RF board 10 of the electronic apparatus 1 illustrated in FIG. 1 is replaced with the RF board 10A, and the heat sink 20 (see FIG. 1) is omitted. The RF board 10A is different from the RF board 10 illustrated in FIG. 1 in that the RF board 10A does not include the metallic portion 15.

As described above, the electronic apparatus 1A may be mounted on the RF board 10A that does not include the metallic portion 15. In this case, heat of the semiconductor chip 110 is propagated to the pad 11B of the RF board 10 through the pad 111, the solder ball 140A, and the metallic pillar 150, and is released from the RF board 10 to the air. When the amount of heat dissipated from the semiconductor chip 110 is relatively small, the configuration may be the same as that of the electronic apparatus 1A.

Even when the semiconductor device 100 is mounted on the RF board 10A which does not include the metallic portion 15 and to which the heat sink 20 is not attached, the risk of generating solder bridging can be significantly reduced, and the reliability of the semiconductor device 100 and the electronic apparatus 1A can be increased.

### <Second Modification>

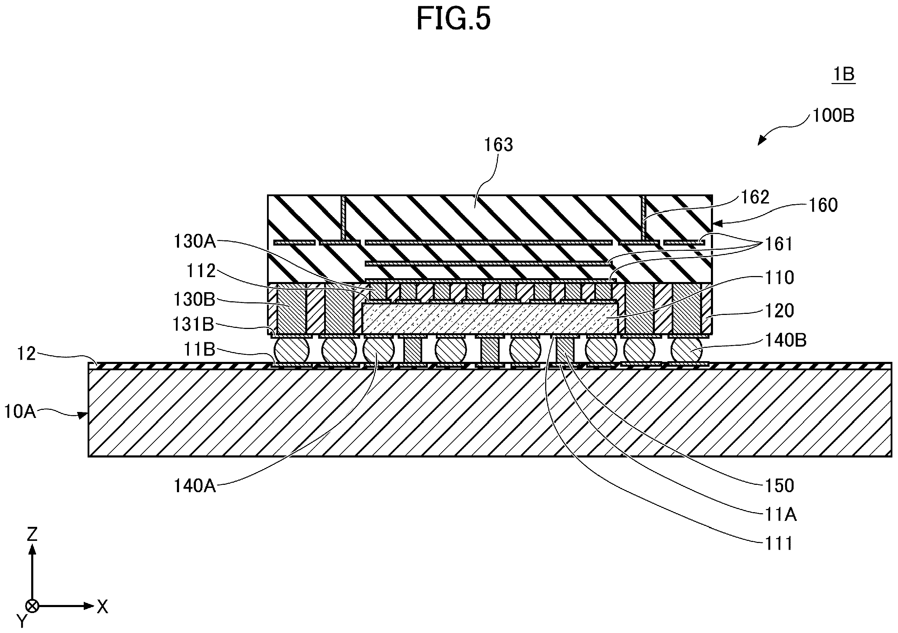

FIG. 5 is a diagram illustrating a semiconductor device 100B and an electronic apparatus 1B according to a second modification of the embodiment. Here, differences from the semiconductor device 100 and the electronic apparatus 1A of the first modification of the embodiment illustrated in FIG. 4 will be described.

The electronic apparatus 1B includes a semiconductor device 100B and an RF board 10A. The semiconductor device 100B has a structure in which the antenna 170 is omitted from the semiconductor device 100 (see FIGS. 1 and 4).

In FIGS. 1 and 2, the semiconductor device 100 is a wireless communication device that can be mounted on a wireless unit of a front end of a base station as an example, and the RF board 10 is a motherboard of the base station as an example. However, even in applications other than the above application and the like, for example, when the pitch between the solder balls is reduced with an increase in the frequency of a signal, and the heat density of the semiconductor chip 110 is high, there is a risk of lowering the reliability due to solder bridging.

In such a case, the risk of solder bridging can be significantly reduced by providing the solder balls 140A and the metallic pillars 150 in the region A, in which the semiconductor chip 110 is included in plan view, and the reliability of the semiconductor device 100B and the electronic apparatus 1B can be increased.

### <Effects>

A semiconductor device 100 includes a semiconductor chip 110 having a first surface (lower surface) and a second surface (upper surface), the first surface (lower surface) facing a RF board 10 (substrate), the second surface (upper surface) being opposite to the first surface and being a circuit surface; a redistribution layer 160 disposed on the second surface side of the semiconductor chip 110; a solder ball 140A connecting the first surface of the semiconductor chip 110 and the RF board 10; and a metallic pillar 150 connecting the first surface of the semiconductor chip 110 and the RF board 10. Therefore, even when the solder ball 140A is melted by a temperature rise in a reflow process when the semiconductor device 100 is mounted on the RF board 10, the generation of solder bridging can be prevented. Further, even when the solder ball 140A is melted by the temperature rise of the semiconductor chip 110, the generation of solder bridging can be prevented.

Therefore, the semiconductor device 100 with high reliability can be provided.

In the semiconductor device 100 according to the embodiment, heat in the reflow process is released to the RF board 10 by using the high thermal conductivity of the metallic pillars 150 in the region A, and thus the generation of the solder bridging in the region A can be prevented. Thus, the semiconductor device 100 with high reliability can be provided. In addition, the temperature rise of the semiconductor chip 110 can be prevented by utilizing the high thermal conductivity of the metallic pillars 150 in the region A, and the metallic pillars 150 disposed between the solder balls will not be melted by the heat generated by the semiconductor chip 110. Therefore, even when the temperature of the semiconductor chip 110 rises, the generation of solder bridging in the region A can be prevented. Thus, the semiconductor device 100 with high reliability can be provided.

Further, in the semiconductor device 100 according to the embodiment, the mounting accuracy of the semiconductor device 100 on the RF board 10 can be improved by the self-alignment effect of the solder balls 140A. Therefore, the semiconductor device 100 can achieve both a reduction in thermal resistance and excellent mountability.

Further, the semiconductor device 100 may include a plurality of solder balls 140A and a plurality of metallic pillars 150, and the plurality of metallic pillars 150 may be disposed between the plurality of solder balls 140A in a plan view. In this configuration, even when the solder balls 140A are melted due to a temperature rise in a reflow process when the semiconductor device 100 is mounted on the RF board 10, the generation of solder bridging can be prevented by disposing the plurality of metallic pillars 150 between the plurality of solder balls 140A. Further, even when any of the solder balls 140A is melted due to the temperature rise of the semiconductor chip 110, the generation of the solder bridging can be prevented. Therefore, the semiconductor device 100 with higher reliability can be provided. Further, the semiconductor device 100 capable of achieving both the reduction in thermal resistance and the excellent mountability can be provided.

The plurality of metallic pillars 150 and the plurality of solder balls 140A may be alternately disposed in the X direction (first axis direction) in a plan view. Even when the solder balls 140A are melted by a temperature rise in the reflow process, the generation of solder bridging in the X direction can be prevented. Therefore, the semiconductor device 100 having higher reliability in the X direction can be provided. Further, the semiconductor device 100 capable of achieving both the reduction in thermal resistance and the excellent mountability can be provided. Further, even when the temperature of the semiconductor chip 110 rises, the generation of solder bridging can be prevented. Thus, the semiconductor device 100 having higher reliability in the X direction can be provided.

The plurality of metallic pillars 150 and the plurality of solder balls 140A may be alternately disposed in the Y direction (second axis direction) intersecting the X direction (first axis direction) in a plan view. Even when the solder balls 140A are melted by a temperature rise in the reflow process, the generation of solder bridging in the Y direction can be prevented. Therefore, the semiconductor device 100 having higher reliability in the Y direction can be provided. Further, the semiconductor device 100 capable of achieving both the reduction in thermal resistance and the excellent mountability can be provided. Further, even when the temperature of the semiconductor chip 110 rises, the generation of solder bridging can be prevented. Thus, the semiconductor device 100 having higher reliability in the Y direction can be provided.

The solder balls 140A and the metallic pillars 150 are disposed in a region A (first region) including the semiconductor chip 110 in a plan view, and the semiconductor device 100 may further include solder balls 140B disposed in a region B (second region) outside the region A in a plan view. Even when the solder balls 140A are melted by a temperature rise in a reflow process when the semiconductor device 100 is mounted on the RF board 10, the generation of solder bridging in the region A can be prevented. Further, even when the solder balls 140A are melted due to the temperature rise of the semiconductor chip 110, the generation of solder bridging in the region A can be prevented. Further, the solder balls 140B in the region B are added, so that a higher self-alignment effect can be obtained, and the mounting accuracy when the semiconductor device 100 is mounted on the RF board 10 can be further increased. Therefore, the semiconductor device 100 having higher reliability and capable of achieving both a reduction in thermal resistance and better mountability can be provided.

In addition, the semiconductor device 100 may further include a redistribution layer 160 disposed on the second surface (upper surface) side of the semiconductor chip 110. In the configuration in which the redistribution layer 160 disposed on the second surface (upper surface) side of the semiconductor chip 110, even when the solder balls 140A are melted by a temperature rise in a reflow process when the semiconductor device 100 is mounted on the RF board 10, the generation of solder bridging can be prevented. Further, even when the solder balls 140A are melted by the temperature rise of the semiconductor chip 110, the generation of solder bridging can be prevented. Therefore, the semiconductor device 100 with high reliability can be provided.

The semiconductor device may further include an antenna 170 that is disposed on a side opposite to the semiconductor chip 110 with respect to the redistribution layer 160 and that is connected to the semiconductor chip 110 via the redistribution layer 160. When the semiconductor chip 110 controls wireless communication, the wireless communication with an external device may be performed through the antenna 170. Since the amount of heat generated by the semiconductor chip 110 increases upon wireless communication being performed, the semiconductor device 100 capable of suppressing the generation of solder bridging is effective.

The electronic apparatus 1 includes a semiconductor device 100, and an RF board 10 on which the semiconductor device 100 is mounted. The semiconductor device 100 includes a semiconductor chip 110 having a first surface (lower surface) and a second surface (upper surface), the first surface (lower surface) facing the RF board 10 (substrate), and the second surface (upper surface) being opposite to the first surface and being a circuit surface; a redistribution layer 160 disposed on the second surface side of the semiconductor chip 110; solder balls 140A connecting the first surface of the semiconductor chip 110 and the RF board 10; and metallic pillars 150 connecting the first surface of the semiconductor chip 110 and the RF board 10. Therefore, even when the solder balls 140A are melted by a temperature rise in a reflow process when the semiconductor device 100 is mounted on the RF board 10, the generation of solder bridging can be prevented. Further, even when the solder balls 140A are melted by the temperature rise of the semiconductor chip 110, the generation of solder bridging can be prevented.

Therefore, the electronic apparatus 1 with high reliability can be provided.

In the electronic apparatus 1 according to the embodiment, heat of the semiconductor chip 110 is released to the RF board 10 by using the high thermal conductivity of the metallic pillar 150 in the region A. Thus, it is possible to suppress the temperature rise of the semiconductor chip 110. In addition, since the metallic pillar 150 is disposed between the solder balls 140A, the metallic pillar 150 is not melted by the heat generated by the semiconductor chip 110. Thus, the generation of solder bridging in the region A can be prevented. Thus, the electronic apparatus 1 with high reliability can be provided.

Further, the mounting accuracy when the electronic apparatus 1 is mounted on the RF board 10 can be increased by the self-alignment effect of the solder balls 140A. Therefore, the electronic apparatus 1 can achieve both the reduction in thermal resistance and excellent mountability.

Further, the RF board 10 may include a metallic portion 15 connected to the metallic pillar 150. Since heat is dissipated from the metallic pillar 150 to the metallic portion 15, the temperature rise of the semiconductor chip 110 may be effectively prevented. Therefore, it is possible to provide the electronic apparatus 1 with higher reliability. In addition, it is possible to provide the electronic apparatus 1 capable of achieving both further reduction in thermal resistance and excellent mountability.

Although the semiconductor device and the electronic apparatus according to the embodiments of the present disclosure have been described above, the present disclosure is not limited to the specifically disclosed embodiments, and various modifications and changes can be made without departing from the scope of the claims.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alterations could be made hereto without departing from the spirit and scope of the invention.

### Description of Reference Numerals

- 1,1A,1B: electronic apparatus
- 10: RF board (an example of a substrate)
- 15: metallic portion
- 20: heat sink
- 100: semiconductor device
- 110: semiconductor chip
- 111,112: pad
- 120: mold resin
- 130A,130B: metallic pillar
- 140A: solder ball (an example of a first bump)
- 140B: solder ball (an example of a second bump)
- 150: metallic pillar (an example of a metallic pillar)
- 160: redistribution layer
- 170: antenna

## Claims

1. A semiconductor device (100) comprising:
a semiconductor chip (110) having a first surface and a second surface, the first surface facing a substrate (10), the second surface being opposite to the first surface and being a circuit surface;
a first bump (140A) connecting the first surface of the semiconductor chip and the substrate; and
a metallic pillar (150) connecting the first surface of the semiconductor chip and the substrate.

2. The semiconductor device according to claim 1, comprising:
a plurality of first bumps (140A); and
a plurality of metallic pillars (150),
wherein the plurality of metallic pillars are disposed between the plurality of first bumps in a plan view, each of the plurality of first bumps being the first bump, and each of the plurality of metallic pillars being the metallic pillar.

3. The semiconductor device according to claim 2, wherein the plurality of metallic pillars (150) and the plurality of first bumps (140A) are alternately disposed in a first axis direction in a plan view.

4. The semiconductor device according to claim 3, wherein the plurality of metallic pillars (150) and the plurality of first bumps (140A) are alternately disposed in a second axis direction intersecting the first axis direction in a plan view.

5. The semiconductor device according to any one of claims 1 to 4, wherein the metallic pillar (150) is made of a metal having a higher thermal conductivity than the first bump (140A).

6. The semiconductor device according to claim 2, further comprising:
a plurality of second bumps (140B),
wherein the plurality of first bumps (140A) and the plurality of metallic pillars (150) are disposed in a first region in a plan view, the first region including the semiconductor chip, and
the plurality of second bumps (140B) are disposed in a second region outside the first region in a plan view.

7. The semiconductor device according to claim 1, further comprising:
a redistribution layer (160) disposed on the second surface side of the semiconductor chip (110).

8. The semiconductor device according to claim 7, further comprising:
an antenna (170) disposed on a side opposite to the semiconductor chip (110) with respect to the redistribution layer (160), the antenna being connected to the semiconductor chip via the redistribution layer.

9. The semiconductor device according to claim 1, wherein the first bump (140A) is a solder ball.

10. The semiconductor device according to claim 6, wherein each of the second bumps (140B) is a solder ball.

11. An electronic apparatus (1) comprising:
a semiconductor device (100);
a substrate (10) on which the semiconductor device is mounted,
wherein the semiconductor device (100) includes
a semiconductor chip (110) having a first surface and a second surface, the first surface facing the substrate, and the second surface being opposite to the first surface and being a circuit surface;
a redistribution layer (160) disposed on the second surface side of the semiconductor chip (110);
a first bump (140A) connecting the first surface of the semiconductor chip and the substrate; and
a metallic pillar (150) connecting the first surface of the semiconductor chip (110) and the substrate (10).

12. The electronic apparatus according to claim 11, wherein the substrate (10) includes a metallic portion (15) connected to the metallic pillar (150).
